# EUROPEAN PATENT APPLICATION

(11) **EP 1 837 303 A1**
(43) Date of publication of application: **26.09.2007**
(21) Application number: 06111686.9
(22) Date of filing: 24.03.2006
(51) Int. Cl.: B81B 7/00

(54) **Integrated pedestal mount for mems structure**

(71) Applicant: Infineon Technologies SensoNor AS, 3192 Horten (NO)
(72) Inventor: Kvisteroy, Terje, 3181, Horten (NO)
(74) Representative: Haley, Stephen

(57) **Abstract**

A substrate is provided for supporting a MEMS device. The substrate comprises: a housing with an integral pedestal mount for supporting a MEMS device, in use. The substrate can be combined with a MEMS device to form a sensor.

## Description

The present invention concerns packaging for a sensor and more particularly an integrated pedestal mount for a micro-electro-mechanical system (MEMS) structure.

MEMS structures are widely used in such varied technological fields as the automobile industry, biomedical applications, and the electronics industry. MEMS structures are used as sensors of various types. Examples of MEMS structures include: MEMS gyroscopes that can be used by the automobile industry to detect yaw; MEMS accelerometers which can be used to deploy airbags in automobiles; and MEMS pressure sensors which, appropriately manufactured can be used to measure car tyre pressure or even blood pressure.

MEMS structures typically include a mechanical structure that is fabricated onto a silicon substrate using micro-machining techniques.

As a result of their high surface area to volume ratio, MEMS structures are very sensitive to environmental parameters that may be connected to their intended function. In particular, they are very sensitive to thermal and mechanical stresses that may ultimately result in their failure and which can result in inaccuracy of their output.

It is therefore desirable to isolate the MEMS structure from its surrounding in order to minimise adverse effects such as warping of the sensor which adversely affects its performance.

It has been suggested to provide a soft material layer between a sensor and its respective supporting substrate. Furthermore, two layers of this soft material can be provided with an interstitial mounting plate. These additional layers require precise control of the quantity of adhesive used as well as precise control of the placement of the sensor.

Furthermore, a sensor isolation system is known that consists of a compliant interposer that is disposed between the package and the sensor in order to avoid thermal and mechanical stresses affecting the performance of the sensor. The compliant interposer comprises members that absorb the stresses that are present in the package in order to avoid their transference to the sensor. The provision of a compliant interposer that is not soldered in place, but rather is provided using an interference fit, overcomes the problem of precisely controlling the solder used in the connection between the sensor and the package.

A further development of this principle provides an alternative solution to the problems associated with solder and epoxy bonding by providing pillars on two co-operating substrates so that the two pieces slot together using an interference fit and provide an enclosed space in which the sensor is housed.

All of the above-mentioned approaches to reducing the stresses to which a sensor is exposed rely on precise machining of multiple co-operating parts. These parts, whether they take the form of soft layers of material with interstitial mounting plates; compliant interposers or co-operating substrates all add to the complexity of the manufacture of such devices.

In today's highly competitive electronics market it is crucial to be able to produce high quality products both reliably and economically. As a device becomes more complex, the manufacturing requirements also become more complex and therefore increasing the number of component parts required can increase the cost of production of the article. Furthermore, as many products are miniaturised the manufacturing tolerances on each of the parts must improve in line with the reduction in the overall size of the product in order to maintain consistency of manufacture. Moreover, the use of more parts imposes a critical challenge on matching the thermal properties of all parts involved.

According to the present invention there is therefore provided a substrate for supporting a MEMS device, wherein the substrate comprises: a housing with an integral pedestal mount for supporting a MEMS device, in use. The integral pedestal ensures that the MEMS structure is isolated from a substantial proportion of the stresses and strains borne by the substrate.

By mounting the MEMS device directly onto the pedestal part of the substrate, the resulting sensor is more robust. In particular, it is possible for the sensor to retain its rigidity and stability over a wide range of temperature, vibrational stress and g-loading.

By reducing the number of parts and thereby the number of different materials involved, the sensor of the present invention is also more reliable over time as a result of the low hysteresis effects that result from the integral construction of the substrate and pedestal.

The substrate of the present invention can be utilised with any standard MEMS structure.

The pedestal mount is preferably elongate and provided with a smaller diameter than the cross section of the MEMS device. The housing may be ceramic or polymer based. The substrate may further comprise an inlet hole.

A sensor may be formed using the substrate and a MEMS device. The sensor may further comprise wire bonds for outputting signals from the sensor.

Furthermore, according to the present invention there is provided a method of manufacturing a sensor, the method comprising the steps of forming the substrate using a multi-layering technique or moulding technique; and bonding the MEMS device directly to the pedestal mount. The die bonding may be direct bonding or adhesive bonding.

The method of the present invention uses either a ceramic multi-layer technique or a polymer moulding technique to provide the exact topology of the substrate as required. This results in a reduction in post-fabrication modifications that can introduce additional stresses to the substrate. Both techniques are well-established methods of low cost 3D manufacturing technologies.

The present invention will now be described with reference to the accompanying drawings in which:
Figure 1 shows a cross section of a first example of a sensor according to the present invention;
Figure 2 shows a cross section of a second example of a sensor according to the present invention.

Throughout the following description like reference numerals will be used for equivalent parts of each of the two examples,

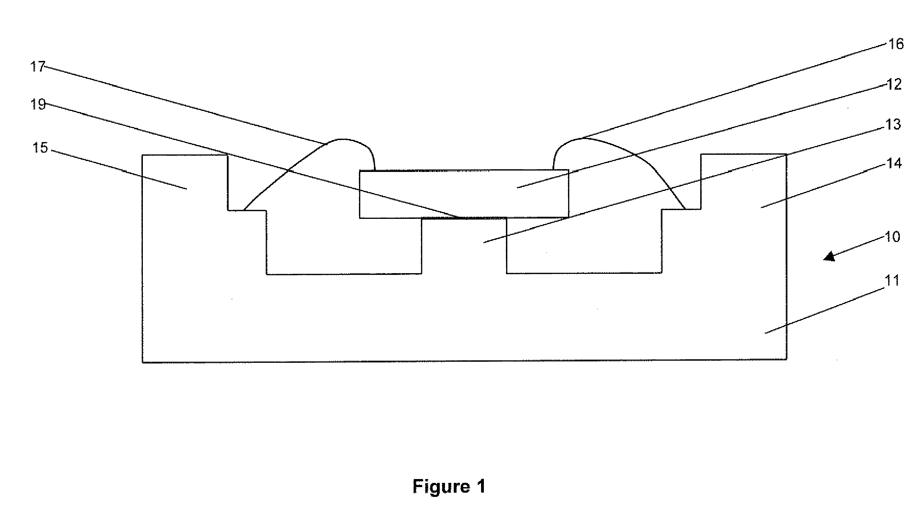

Figure 1 shows a sensor 10 that comprises a substrate 11 and a MEMS structure 12. The substrate 11 is formed from a ceramic material or a polymer material. A ceramic material can be tailored to provide a close match for the coefficient of thermal expansion to either Si or glass and ceramics are known to maintain their material characteristics over time and thermal cycling resulting in a very stable material. An example of ceramic material may be Aluminium Nitride (AIN). Polymer materials are preferable for low cost applications due to the extremely low cost moulding techniques. Examples of polymers are injection moulded glass-fibre, reinforced nylon or PPS, or Liquid Crystal Polymer (LCP).

The substrate 11 is provided with an integral pedestal 13 onto which the MEMS structure 12 is bonded using adhesive 19. The pedestal 13 is elongate and preferably has a circular cross section. Although the man skilled in the art would appreciate that any shape of cross section could be used, he would also appreciate that a circular cross section minimises the stresses by reducing the number of sharp corners. The pedestal 13 has a constant cross sectional area or can be tapered having the smallest cross section closest to the MEMS die. Depending on the die bonding technique the surface of the pedestal may be metallised.

The substrate 11 is further provided with protective portions 14, 15 that extend beyond the MEMS structure 12. These portions 14, 15 provide an enclosed environment for the MEMS structure 12. In addition, the portion 14, 15 are used for attaching wire bonds 16, 17 which also attach to the MEMS structure 12.

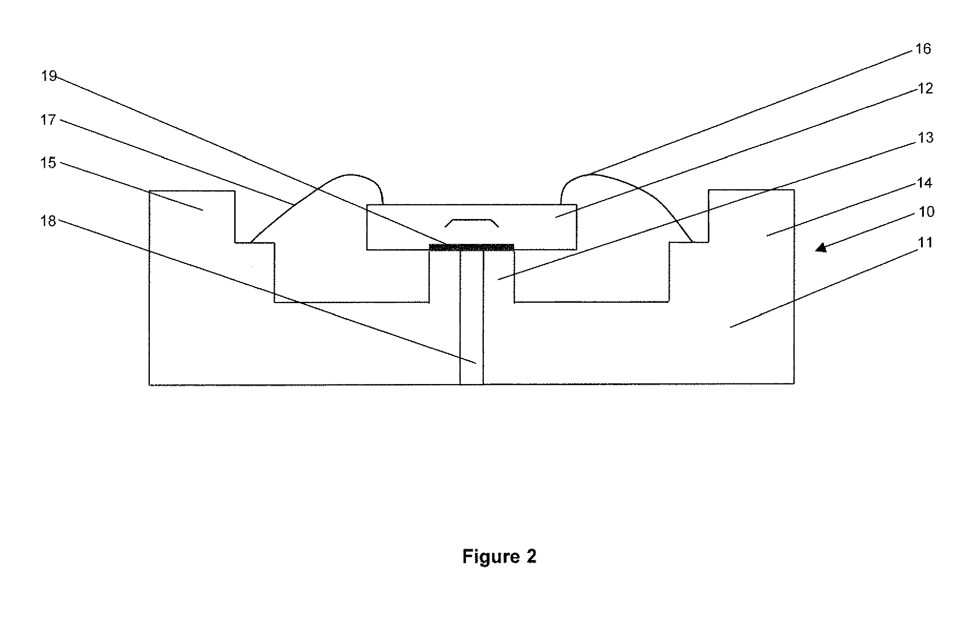

In addition to the features described above in connection with Figure 1, the sensor 10 of Figure 2 is provided with an inlet hole 18. This sensor 10 is suitable for use as a pressure sensor with the inlet hole 18 allowing the fluid to be measured to impinge on the sensor 10.

The sensors 10 shown in Figures 1 and 2 are compatible with any standard MEMS structure 12 and no specific adaptation of the MEMS structure 12 is required before it can be used in the sensor 10 when using an adhesive for the die bonding process.

For direct bonding, metallizing or oxidizing the reverse side of the MEMS die may be necessary depending on the die bonding process parameters. For MEMS dies containing glass substrate or glass layer direct bonding can be performed directly.

The sensors 10 shown in Figures 1 and 2 are manufactured as follows. Firstly, the substrate 12 is formed using a multi-layer technique for ceramic material or moulding technique for polymer material. The MEMS structure is then bonded to the pedestal 13 using either direct bonding, such as anodic or metal bonding. Alternatively, the bonding may be adhesive using solder or an organic substance, such as epoxy.

## Claims

1. A substrate for supporting a MEMS device, wherein the substrate comprises:
a housing with an integral pedestal mount for supporting a MEMS device, in use.

2. The substrate according to claim 1, wherein the pedestal mount is elongate.

3. The substrate according to claim 1 or claim 2, wherein the pedestal mount has a smaller diameter than the cross section of the MEMS device.

4. A substrate according to any one of claims 1 to 3, wherein the housing is ceramic.

5. A substrate according to any of claims 1 to 3, wherein the housing is polymer based.

6. A substrate according to any one of the preceding claims, further comprising an inlet hole.

7. A sensor comprising:
a substrate according to any one of claims 1 to 6, and
a MEMS device.

8. The sensor according to claim 7, further comprising wire bonds for outputting signals from the sensor.

9. A method of manufacturing the sensor according to claim 7 or claim 8, the method comprising the steps of:
forming the substrate using a multi-layering technique or moulding technique;
bonding the MEMS device directly to the pedestal mount.

10. The method according to claim 9, wherein the die bonding is direct bonding.

11. The method according to claim 9, wherein the die bonding is adhesive bonding.
